# EUROPEAN PATENT APPLICATION

(11) **EP 4 391 023 A1**
(43) Date of publication of application: **26.06.2024**
(21) Application number: 23193297.1
(22) Date of filing: 24.08.2023
(51) Int. Cl.: H01L 21/311, H01L 21/3065, H01L 21/306

(54) **METHOD OF PLASMA ETCHING**

(30) Priority: 22.12.2022 GB 202219567
(71) Applicant: SPTS Technologies Limited, Newport Gwent NP18 2TA (GB)
(72) Inventor: KAZEMI, Samira Binte, Newport (GB)
(74) Representative: Wynne-Jones IP Limited

(57) **Abstract**

According to the invention there is provided a method of plasma etching an additive-containing aluminium nitride film, the additive-containing aluminium nitride film containing an additive element selected from scandium (Sc), yttrium (Y) or erbium (Er), the method comprising the steps of:
placing a workpiece upon a substrate support within a plasma chamber, the workpiece comprising a substrate having an additive-containing aluminium nitride film deposited thereon and a mask disposed upon the additive-containing aluminium nitride film which defines at least one trench;
introducing BCl₃ gas into the chamber with a BCl₃ flow rate in sccm;
introducing Cl₂ gas into the chamber with a Cl₂ flow rate in sccm;
introducing an inert diluent gas into the chamber with an inert diluent gas flow rate in sccm; and
establishing a plasma within the chamber to plasma etch the additive-containing aluminium nitride film exposed within the trench;
wherein a ratio of the inert diluent gas flow rate to the sum of the BCl₃ and Cl₂ flow rates is in the range 0.45:1 to 0.75:1 and a ratio of the BCl₃ flow rate to the Cl₂ flow rate is in the range 0.75:1 to 1.25:1.

## Description

This invention relates to a method of plasma etching, with particular reference to a method of plasma etching an additive-containing aluminium nitride film, the additive-containing aluminium nitride film containing an additive element selected from scandium (Sc), yttrium (Y) or erbium (Er). The invention relates also to an associated apparatus for plasma etching an additive-containing aluminium nitride film of this kind.

Aluminium nitride (AIN) and aluminium scandium nitride (AIScN) piezoelectric devices are widely used in a range of RF technologies such as bulk acoustic wave (BAW) devices, piezoelectric micromachined ultrasonic transducers (PMUTs), lamb wave contour mode resonators (CMR), microphones and sensors. Mobile phones typically incorporate a number of AIN and AIScN BAW devices and the generation of higher operating frequencies require the use of thinner BAW devices. Improving the piezoelectric performance for thinner devices is a major challenge as tolerances become tighter and the integration of these devices on circuit boards becomes more complicated. The addition of Sc is known to improve the piezoelectric properties of BAW devices. However, there are a number of problems associated with the etching of AIScN which are particularly troublesome with high scandium contents.

As the percentage of Sc in doped AIN increases, the etch rate typically decreases when using standard chlorine (Cl₂)/argon (Ar) based chemistries. This decrease results in a lower AIScN selectivity to masks (such as photoresist or SiOz masks), which increases the critical dimension (CD) and consequently results in a shallower sidewall angle within the AIScN trenches. Common methods of controlling the sidewall profile include adjusting the slope of the pre-etch mask, changing the platen bias, etchant gas flow or process pressure. These methods are commonly effective for lower Sc content AIScN, but at higher Sc percentages the etch becomes increasingly physical, decreasing the overall effectiveness of these methods. Similar effects are observed with AIYN and AlErN films.

The decrease in AIScN etch rate also reduces the selectivity to metal underlayers, leading to increased underlayer loss which can impair the performance of some devices, such as BAW filters. The lower electrical contact to BAW devices is typically molybdenum (Mo), tungsten (W) or platinum (Pt) and if excessive amounts of metal are removed, owing to the reduced etch rate of AIScN, the electrical resistance of the contact will increase, resulting in a degradation of device performance. Typical changes to increase the AIScN etch rate, such as increased platen bias or increased Cl₂ flow, may ultimately have little-to-no impact on the sidewall angle or underlayer selectivity, or in some cases may even exacerbate the issue.

AIScN etch processes typically comprise two etch steps. The first step is a main, bulk etch process with a high etch rate, good selectivity to the mask material, a steep sidewall profile, and minimum footing. Normally 80-85% of the material is etched by the main etch. The second step is a soft-landing etch step which should have good selectivity to the underlying electrode. This is generally a low etch rate process. As this process typically etches only 15-20% of the material, the etch rate and the etch profile can be sacrificed for good selectivity.

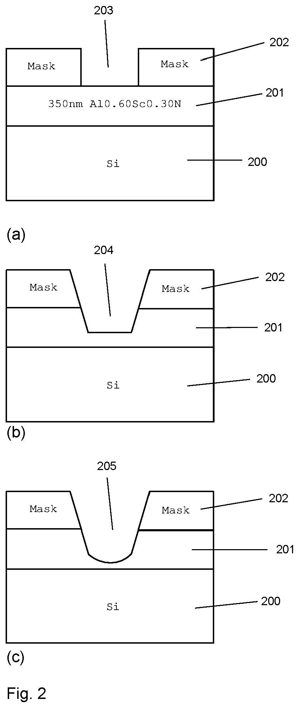

For the avoidance of doubt, footing refers to an undesirable deviation away from an ideal flat bottom surface at the base of an etched feature. This is typically measured using SEM cross sections of etched features. Footing is caused by a difference in the etch rate between the region close to the mask and the region far from the mask, at the base of the etched feature. Figure 2 shows the production of etch features with and without footing. More specifically, Figure 2(a) shows a workpiece prior to etching. The workpiece comprises a silicon wafer 200 having a layer 201 of AIScN deposited thereon. A mask 202 is formed on the AIScN layer 201 to leave an opening 203 through which the AIScN layer can be etched. Figure 2(b) shows the workpiece after etching of the AIScN layer 201 to produce a trench 204 which has a flat bottomed base with no footing. Figure 2(c) shows the workpiece after etching of the AIScN layer 201 to produce a trench 205 which exhibits footing in the form of a concave base profile.

The present invention, in at least some of its embodiments, seeks to address at least some of the above-mentioned problems.

According to a first aspect of the invention there is provided a method of plasma etching an additive-containing aluminium nitride film, the additive-containing aluminium nitride film containing an additive element selected from scandium (Sc), yttrium (Y) or erbium (Er), the method comprising the steps of:
placing a workpiece upon a substrate support within a plasma chamber, the workpiece comprising a substrate having an additive-containing aluminium nitride film deposited thereon and a mask disposed upon the additive-containing aluminium nitride film which defines at least one trench;
introducing BCl₃ gas into the chamber with a BCl₃ flow rate in sccm;
introducing Cl₂ gas into the chamber with a Cl₂ flow rate in sccm;
introducing an inert diluent gas into the chamber with an inert diluent gas flow rate in sccm; and
establishing a plasma within the chamber to plasma etch the additive-containing aluminium nitride film exposed within the trench;
wherein a ratio of the inert diluent gas flow rate to the sum of the BCl₃ and Clz flow rates is in the range 0.45:1 to 0.75:1 and a ratio of the BCl₃ flow rate to the Clz flow rate is in the range 0.75:1 to 1.25:1.
In this way, the problem of footing can be reduced.

The ratio of the inert diluent gas flow rate to the sum of the BCl₃ and Clz flow rates can be in the range 0.48:1 to 0.6:1.

The ratio of the BCl₃ flow rate to the Cl₂ flow rate can be in the range 0.9:1 to 1.1:1, optionally in the range 0.95:1 to 1.05:1, optionally about 1.0: 1.

The BCl₃ flow rate and the Clz flow rate can be each in the range 20 to 30 sccm, optionally about 25 sccm.

The inert diluent gas flow rate can be in the range 20 to 30 sccm, optionally about 25 sccm.

The plasma etch can be performed with a gas pressure in the chamber of no greater than 5 mTorr.

An inductively coupled plasma (ICP) can be established within the chamber using a power in the range 750 to 1500 W.

An RF bias signal having a power in the range 1000 to 1500 W can be applied to the substrate support during the step of establishing a plasma within the chamber.

The method of the first aspect of the invention can be performed as a first, main, plasma etching step to etch a majority of the additive-containing aluminium nitride film exposed within the trench, and then followed by a second plasma etching step to etch the remaining additive-containing aluminium nitride film exposed within the trench. The second aspect of the invention describes a second plasma etching step which can be used in conjunction with the first aspect of the invention. In principle, the first aspect of the invention does not require a second plasma etching step of this kind to be performed.

According to a second aspect of the invention there is provided a method of plasma etching an additive-containing aluminium nitride film, the additive-containing aluminium nitride film containing an additive element selected from scandium (Sc), yttrium (Y) or erbium (Er), the method comprising the steps of:
placing a workpiece upon a substrate support within a plasma chamber, the workpiece comprising a substrate having a metal film disposed thereon, an additive-containing aluminium nitride film deposited on the metal film and a mask disposed upon the additive-containing aluminium nitride film which defines at least one trench;
performing a first, main, plasma etching step in which BCl₃ gas, Cl₂ gas and an inert diluent gas are introduced into the chamber and a plasma is established within the chamber to plasma etch a majority of the additive-containing aluminium nitride film exposed within the trench; and
performing a second plasma etching step in which BCl₃ gas and an inert diluent gas are introduced into the chamber but Cl₂ gas is not introduced into the chamber and a plasma is established within the chamber to plasma etch the remaining additive-containing aluminium nitride film exposed within the trench thereby revealing the metal film.

In this way, improved selectivity to metal underlayers can be achieved. Selectivity can be defined as the etch rate of the additive-containing aluminium nitride film / the etch rate of the metal film.

The BCl₃ gas can be introduced into the chamber with a BCl₃ flow rate in the range 50 to 100 sccm, optionally in the range 75 to 95 sccm, during the step of performing a second plasma etching step.

The inert diluent gas can be introduced into the chamber with an inert diluent gas flow rate in the range 10 to 20 sccm during the second plasma etching step.

In the second plasma etching step an inductively coupled plasma (ICP) can be established within the chamber using a power in the range 400 to 700 W.

An RF bias signal having a power in the range 500 to 700 W can be applied to the substrate support during the second plasma etching step.

The metal film can be a molybdenum film. Alternatively, the metal film can be a tungsten, ruthenium or platinum film.

The first plasma etching step and/or the second plasma etching step can be performed with a gas pressure in the chamber of no greater than 5 mTorr.

The first aspect of the invention can be used as the first plasma etching step.

The inert diluent gas can be Argon. Other inert gases, such as other Noble gases, can be contemplated.

The substrate can be a semiconductor substrate, optionally a silicon substrate such as a silicon wafer. The silicon wafer can be of any suitable diameter, such as 150mm or 200mm diameter.

The additive-containing aluminium nitride film can be an aluminium scandium nitride film defined by the formula AlₓSc_{y}N, where x + y = 1. For the avoidance of doubt, the metal contents x and y in this formula are atomic contents. It will be appreciated that the At% of Al is 100x and the At% of Sc is 100y. The scandium content y can be 0.30 or more. The scandium content y can be 0.35 or more, optionally about 0.4. The scandium content y can be 0.50 or less, optionally 0.45 or less. All aspects of the invention are particularly effective in the etching of AIScN films of high Sc content.

The mask can be a photoresist mask. The mask can be a silicon oxide mask.

The plasma can be an inductively coupled plasma (ICP).

According to a third aspect of the invention there is provided an apparatus for plasma etching an additive-containing aluminium nitride film containing an additive element selected from scandium (Sc), yttrium (Y) or erbium (Er) through a mask, the apparatus comprising:
a chamber;
a substrate support disposed within the chamber;
a gas delivery system for introducing into the chamber BCl3 gas with a BCl3 flow rate in sccm, Cl₂ gas with a Cl₂ flow rate in sccm and an inert diluent gas with an inert diluent flow rate in sccm;
a plasma generation device for sustaining a plasma within the chamber for etching a workpiece comprising a substrate having an additive-containing aluminium nitride film deposited thereon and a mask disposed upon the additive-containing aluminium nitride film which defines at least one trench; and
a controller configured to control the apparatus to perform plasma etching to etch the additive-containing aluminium nitride film exposed within the trench, wherein the controller controls the gas delivery system to maintain a ratio of the inert diluent gas flow rate to the sum of the BCl₃ and Clz flow rates in the range 0.45:1 to 0.75:1 and a ratio of the BCl3 flow rate to the Clz flow rate in the range 0.75:1 to 1.25:1.

According to a fourth aspect of the invention there is provided an apparatus for plasma etching an additive-containing aluminium nitride film containing an additive element selected from scandium (Sc), yttrium (Y) or erbium (Er) through a mask, the apparatus comprising:
a chamber;
a substrate support disposed within the chamber;
a gas delivery system for introducing into the chamber BCl₃ gas, Cl₂ gas and an inert diluent gas;
a plasma generation device for sustaining a plasma within the chamber for etching a workpiece comprising a substrate having a metal film disposed thereon, an additive-containing aluminium nitride film deposited on the metal film and a mask disposed upon the additive-containing aluminium nitride film which defines at least one trench; and
a controller configured to control the apparatus to perform a first, main, plasma etching step in which BCl3 gas, Clz gas and an inert diluent gas are introduced into the chamber and a plasma is established within the chamber to etch a majority of the additive-containing aluminium nitride film exposed within the trench, and a second plasma etching step in which BCl₃ gas and an inert diluent gas are introduced into the chamber but Cl₂ gas is not introduced into the chamber and a plasma is established within the chamber to etch the remaining additive-containing aluminium nitride film exposed within the trench thereby revealing the metal film.

The plasma generation device can be an inductively coupled plasma (ICP) device.

For the avoidance of doubt, whenever reference is made herein to 'comprising' or 'including' and like terms, the invention is also understood to include more limiting terms such as 'consisting' and `consisting essentially'.

Whilst the invention has been described above, it extends to any inventive combination of the features set out above, or in the following description, drawings or claims. For example, any features disclosed in relation to the one aspect of the invention can be combined with any features disclosed in relation to the any other aspect of the invention.

Embodiments of the invention will now be described, by way of example only, with reference to the accompanying drawings, in which:
Figure 1 is schematic illustration of a plasma etching apparatus for etching an additive-containing aluminium nitride film;
Figure 2 is a cross sectional schematic representation of a workpiece (a) prior to etching, (b) after etching and with no footing and (c) after etching and with footing present;
Figure 3 shows SEM images obtaining after etching using Ar flow rates varying from 10 to 35 sccm;
Figure 4 shows SEM images obtaining after etching using various ratios of the BCl₃/ Cl₂ flow rates;
Figure 5 is a cross sectional schematic representation of a workpiece having an underlying molybdenum film beneath a AIScN layer; and
Figure 6 shows change in selectivity with change in platen power.

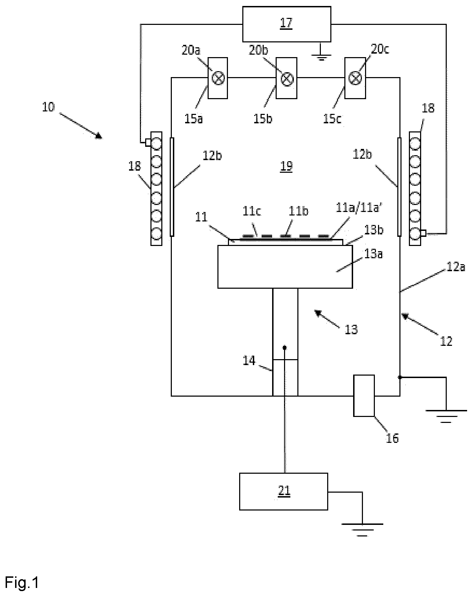

Referring to Figure 1 of the drawings, there is provided a schematic illustration of an apparatus 10 for plasma etching a workpiece 11, and comprises a process chamber 12, within which the plasma etching of the workpiece 11 is performed.

The apparatus 10 further comprises a substrate support 13. The substrate support can be a platen assembly 13, which may also be formed of a metal, such as aluminium, disposed within the chamber 12, but which is electrically isolated from the chamber walls 12a by conventional means, such as ceramic breaks 14. The substrate support can also comprise an electrostatic chuck (ESC), which can be attached to the surface of the platen assembly. The platen assembly 13 comprises a body 13a having a support surface 13b for receiving the workpiece 11 and is electrically biased using a radio frequency (RF) voltage generator. The provision of a negative bias voltage to the platen assembly 13 for example, can help to control positively charged ion bombardment of the surface of the workpiece 11 from the plasma.

The process chamber 12 comprises chamber walls 12a which may be formed of a metal, such as aluminium for example, and which are typically electrically grounded. The chamber 12 further comprises a first, second and a third gas inlet 15a, 15b, 15c via which a source of BCl3 gas, Cl₂ gas and an inert diluent gas such as argon (not shown) respectively, can fluidly couple for introducing the gases into the chamber 12. The chamber 12 further comprises an outlet 16, via which the gases and any by-products of the etching process can pass out from the chamber 12.

In an embodiment, the plasma is an ICP plasma generated by applying an RF voltage from an RF voltage generator 17, to one or more antenna 18, which are disposed around the chamber 12 and located adjacent a respective dielectric window section 12b formed in the chamber walls 12a. The one or more antenna 18 may comprise a substantially planar spiral configuration, a helical coil configuration or a toroidal configuration, for example, and as with standard practice, impedance matching of the RF signal from the generator 17 with the antenna 18 is carried out to minimize reflection of electrical power from the antenna 18. The antennas 18 are placed around the chamber 12 and the electrical power is inductively coupled into the chamber 12, through the dielectric window sections 12b.

A plasma is generated in a region 19 of the chamber 12 which is disposed above the workpiece 11 so that the workpiece 11 becomes exposed to the plasma. The process gases are introduced into the chamber 12 via a respective flow regulator 20a, 20b, 20c coupled with the respective inlet 15a, 15b, 15c, and the inlet 15a, 15b, 15c and outlet 16 of the chamber 12 are disposed on opposite sides of the plasma region 19 so that the etching gases are required to pass through the chamber 12, via the region 19 and over the workpiece 11, in passing to the outlet 16. SPTS Technologies Ltd An example of a suitable apparatus which can be used to perform the invention is a Synapse (RTM) module produced by the applicant, SPTS Technologies Limited (Newport, UK).

Methods in accordance with the invention will be demonstrated with reference to an AIScN film, but the skilled reader will recognize that the methods are equally applicable to AIYN films and AlErN films.

The workpiece 11 is placed upon a platen 13 within the plasma chamber 12. The workpiece 11 comprises a substrate 11a, such as a silicon wafer substrate, upon which is deposited a piezoelectric AIScN film 11b using a pulsed DC sputtering technique, for example. In an embodiment, the film comprises Al_{0.6}Sc_{0.4}N, namely a film comprising 60% component of aluminium and a 40% component for scandium. This is a high scandium content film and it has been difficult to process films having such high scandium contents using prior art methods. The present invention provides significant improvements in the processing of high scandium content AIScN films. Film composition determination is typically achieved through the use of Energy Dispersive Analysis of X-rays (EDAX). The workpiece 11 further comprises a mask 11b patterned with 5µm-100µm trenches 11c formed upon the film 11a using either photoresist or SiOz hard masks.

With the workpiece 11 positioned upon the platen 13 within the chamber 12, BCl₃ Cl₂ and argon gases are introduced into the chamber 12 via the respective inlet 15a-c using the respective flow regulator 20a-c, and the pressure within the chamber 12 is maintained at approximately 2-5mTorr or substantially 3mTorr by a pressure regulator (not shown). Once the chamber 12 has been suitably conditioned with the gases, an RF potential is applied to the antenna 18, via generator 17 to inductively couple electrical power (henceforth termed the 'source power') into the etching gas, and thus initiate a plasma and commence the etching of the Al_{0.6}Sc_{0.4}N film. A bias voltage carrying a bias power is also applied to the platen assembly 13, through the use of the voltage generator 21, typically operating at 13.56MHz, to provide an etching of the AIScN film 11b.

Footing was reduced by controlling process parameters of the first, main, etch step. Improvements in selectivity were achieved by controlling process parameters of the second, soft-landing etch step.

### Footing Reduction

Etch footing was minimized by controlling the flows of the diluent, BCl₃ and Cl₂ gases. Experiments were performed using workpieces of the type generally shown in Figure 2. More particularly, workpieces were prepared by depositing 350nm thick Al_{0.60}Sc_{0.40}N layers on silicon wafers. For these experiments, the wafers were of 150mm diameter, but the same principles are applicable to wafers of other sizes, such as 200mm diameter wafers. The wafers were patterned with a SiOz mask with <14% open area and a thickness between 1.7-3.5µm. The mask profile was less than 80°. The process was performed to produce 10µm wide trenches.

In the experiments, Ar was used as a dilutant gas and the effect of varying the Ar flow rate into the chamber was investigated. An initial increase of the Ar flow makes the plasma more uniform and minimizes footing by decreasing the loading of the plasma. The process used is physical in nature, with low pressure (2mTorr), high bias power (1300W) and low source power (1000W) with flow rates of 25sccm Cl₂, and 25sccm BCl₃. Ar flow rates were varied from 10sccm to 35sccm.

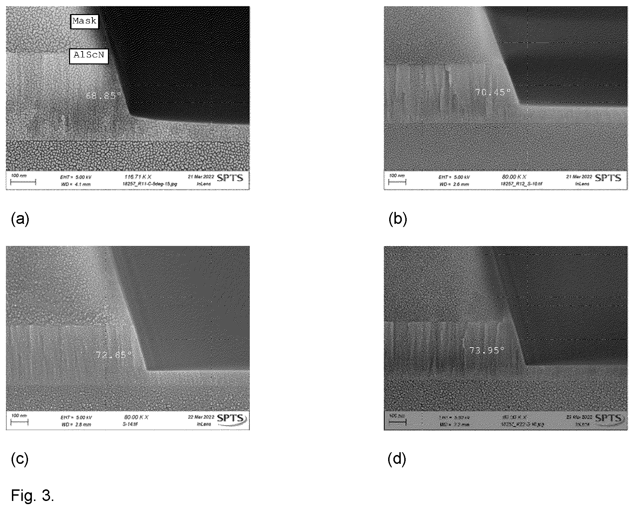

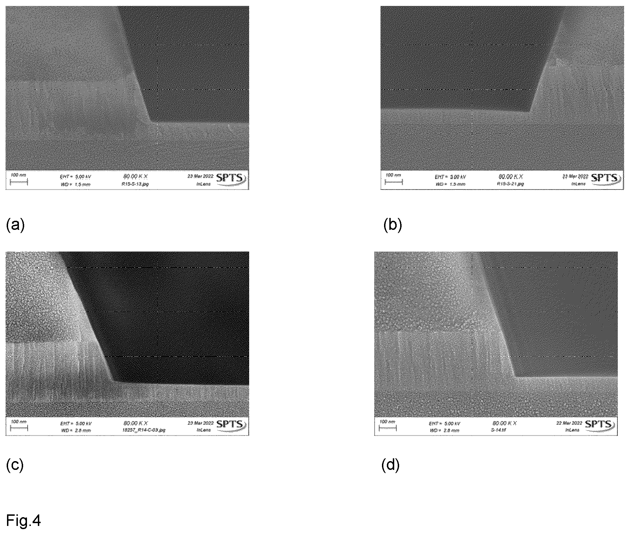

Figure 3 shows SEM images obtaining after etching using Ar flow rates of (a) 10 sccm (b) 20 sccm (c) 25 sccm and (d) 35 sccm. It was observed that the footing decreases from 41nm to 7nm as the Ar flow rate increases from 10 to 25sccm. Figures 4 (a) - (d) also show the sidewall angles of the etched AIScN trench. The results are summarized in Table 1. Further increases in the Ar flow rate resulted in a slight increase in footing.

Without wishing to be bound by any particular theory or conjecture, it is believed that increasing the Ar flow rate dilutes the plasma and makes it more uniform, which in turn decreases the loading effect close to the mask. Also, it is believed that Ar can assist with sputtering ScCl₃ based by-product.

**Table 1. Change in footing with change in Ar flow**

| Cl2/ BCl₃ (sccm) | Ar flow (sccm) | Footing (nm) |
|---|---|---|
| 25/25 | 10 | 41.62 |
| 25/25 | 20 | 30.72 |
| 25/25 | 25 | 7.12 |
| 25/25 | 35 | 11.33 |

Significant improvements in footing can be obtained when the argon flow is controlled in combination with the reactant gas flow.

Two main chlorine based reactant gases (Cl₂ and BCl₃) were used to etch AIScN. Using both BCl₃ and Cl₂ makes the AIScN etch profile steeper. Boron has higher sputter mass that helps with the sputtering of Sc based etch by-product from the sidewall which in turn makes the profile steeper. It has been found that there is an optimum Cl₂: BCl₃ ratio which provides a flat etch front and thereby minimizes footing. When the amount of BCl₃ is low, sputtering of etch by-product from the sidewall is not uniform and this results in inconsistent footing. 1:1 BCl₃: Cl₂ ratio showed minimum footing. If the ratio of BCl₃ is further increased, the footing increases. It is believed that extra Cl ions are available in the plasma environment, and this is believed to favor a chemical etch rather than a physical etch regime in which by-product removal by physical sputtering can take place. Figure 4 shows SEM images obtained after etching using various ratios of the BCl₃/ Cl₂ flow rates. Figures 4 (a) and (b) show the left side and right side, respectively, of a trench etched using a BCl₃: Cl₂ ratio of 0.47. Figures 4 (c) and (d) show results obtained using BCl₃: Cl₂ ratios of 1.0 and 2.13, respectively. The results are summarized in Table 2.

**Table 2. Change in footing with change in ratio of the BCl₃/ Cl₂ flow rates**

| BCl₃ (sccm) | Cl₂ (sccm) | BCl₃/ Cl₂ Ratio | Footing (nm) |
|---|---|---|---|
| 16 | 34 | 0.47 | 24.57 |
| 25 | 25 | 1 | 7.12 |
| 34 | 16 | 2.13 | 35.60 |

It is surprising that a relatively low BCl₃ flow rate can be beneficial when etching higher Sc content AIScN. BCl₃ generates less free Cl, but dissociates into B, B-Cl, B-Cl₂ that helps with sputtering. Therefore, higher BCl₃ flows would be expected to assist in the etching of higher Sc content AIScN as the etch would be expected to be more physical. It is believed that the high sputter mass of boron helps with removing etch by-product, and so an optimum BCl₃: Clz ratio is needed to achieve a flat etch front.

### Selectivity improvement in the soft-landing step

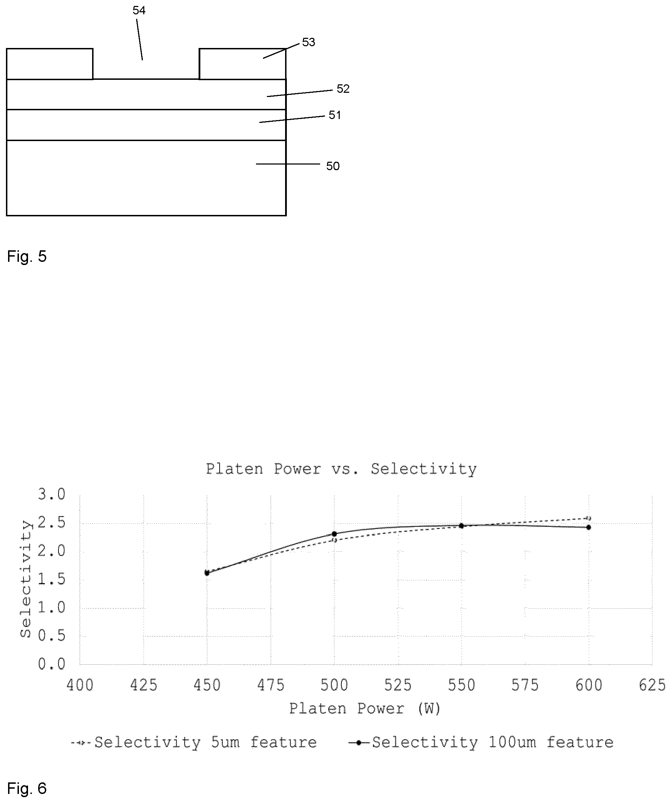

Experiments were performed using workpieces of the type generally shown in Figure 5, which shows a workpiece comprising a silicon wafer 50 having a molybdenum layer 51 formed thereon. A layer 52 of AIScN is deposited on the molybdenum layer 51. A photoresist mask 53 is formed on the AIScN layer 52 to leave an opening 54 through which the AIScN layer can be etched.. More particularly, workpieces were prepared by depositing 200nm thick Al_{0.60}Sc_{0.40}N and molybdenum layers. The layers were pattered using a 4µm thick photoresist mask. For these experiments, the wafers were of 200mm diameter, but the same principles are applicable to wafers of other sizes, such as 150mm diameter wafers. This process is specifically developed for Al_{0.60}Sc_{0.40}N wafers. The process conditions can be readily adapted for AIScN films of different Sc content. Selectivity to the underlying Mo layer was calculated for 5µm and 100µm CD trenches.

The selectivity to the underlying electrode was improved by using only BCl₃ as the reactant gas. Without wishing to be bound by any particular theory or conjecture, it is believed that BCl₃ gas generates less free Cl compared to Cl₂ as BCl₃ is absorbed into the surface of the AIScN and dissociates into BCl₂, BCI, Cl and B. BCl₃ is believed to increase the AIScN etch rate by increasing the sputtering of Sc based by-products with B but decrease the Mo etch rate due to the presence of less active Cl.

The estimated selectivity that can be achieved by a Cl₂+ BCl₃ based soft-landing etch is 0.97:1. It was found that changing the reactant gas to BCl₃ increased the selectivity to 1.6:1. Further process refinements were found to improve the selectivity further. In particular, it was found that the selectivity to the underlying Mo electrode increased with increasing platen power. Increasing platen power from 450W to 600W increased selectivity to Mo from 1.65 to 2.58 for 5µm CD features. For 100µm features selectivity increased with platen power up to 550W. Further increases in platen power resulted in decreased selectivity. Figure 6 shows the change in selectivity with the change in platen power. This process used very low pressure (5mT) and low source power (500W).

An AlScN:Mo selectivity of 2.5:1 was achieved using the process conditions shown in Table 3 for the soft landing etch. Table 3 also shows preferred conditions for the main etch.

**Table 3. Preferred process conditions for minimized footing and high AIScN:Mo selectivity.**

| **Parameter** | **Main Etch** | **Soft Landing** |
|---|---|---|
| Pressure (mTorr) | 2 | 3 |
| Source power (W) | 1000 | 500 |
| Platen power (W) | 1300 | 550 |
| BCl3 flow rate (sccm) | 25 | 85 |
| Cl2 flow rate (sccm) | 25 | 0 |
| Ar flow rate (sccm) | 25 | 15 |

AIScN based device performance depends on bottom electrode thickness. Controlling footing and Mo loss is more difficult for high Scandium content. The present invention can result in low electrode losses which in turn result in improved device performance in a range of applications, such as Bulk Acoustic Wave (BAW) filters for communications (including 5G), microphones, and sensors.

## Claims

1. A method of plasma etching an additive-containing aluminium nitride film, the additive-containing aluminium nitride film containing an additive element selected from scandium (Sc), yttrium (Y) or erbium (Er), the method comprising the steps of:
placing a workpiece upon a substrate support within a plasma chamber, the workpiece comprising a substrate having an additive-containing aluminium nitride film deposited thereon and a mask disposed upon the additive-containing aluminium nitride film which defines at least one trench;
introducing BCl₃ gas into the chamber with a BCl₃ flow rate in sccm;
introducing Cl₂ gas into the chamber with a Cl₂ flow rate in sccm;
introducing an inert diluent gas into the chamber with an inert diluent gas flow rate in sccm; and
establishing a plasma within the chamber to plasma etch the additive-containing aluminium nitride film exposed within the trench;
wherein a ratio of the inert diluent gas flow rate to the sum of the BCl₃ and Clz flow rates is in the range 0.45:1 to 0.75:1 and a ratio of the BCl₃ flow rate to the Clz flow rate is in the range 0.75:1 to 1.25:1.

2. A method according to claim 1 in which the ratio of the inert diluent gas flow rate to the sum of the BCl₃ and Clz flow rates is in the range 0.48:1 to 0.6:1.

3. A method according to claim 1 or claim 2 in which the ratio of the BCl₃ flow rate to the Clz flow rate is in the range 0.9:1 to 1.1:1.

4. A method according to any one of claims 1 to 3 in which the BCl₃ flow rate and the Clz flow rate are each in the range 20 to 30 sccm.

5. A method according to any one of claims 1 to 4 in which the inert diluent gas flow rate is in the range 20 to 30 sccm.

6. A method according to any previous claim performed as a first, main, plasma etching step to etch a majority of the additive-containing aluminium nitride film exposed within the trench, and followed by a second plasma etching step to etch the remaining additive-containing aluminium nitride film exposed within the trench.

7. A method plasma etching an additive-containing aluminium nitride film, the additive-containing aluminium nitride film containing an additive element selected from scandium (Sc), yttrium (Y) or erbium (Er), the method comprising the steps of:
placing a workpiece upon a substrate support within a plasma chamber, the workpiece comprising a substrate having a metal film disposed thereon, an additive-containing aluminium nitride film deposited on the metal film and a mask disposed upon the additive-containing aluminium nitride film which defines at least one trench;
performing a first, main, plasma etching step in which BCl₃ gas, Cl₂ gas and an inert diluent gas are introduced into the chamber and a plasma is established within the chamber to plasma etch a majority of the additive-containing aluminium nitride film exposed within the trench; and
performing a second plasma etching step in which BCl₃ gas and an inert diluent gas are introduced into the chamber but Cl₂ gas is not introduced into the chamber and a plasma is established within the chamber to plasma etch the remaining additive-containing aluminium nitride film exposed within the trench thereby revealing the metal film.

8. A method according to claim 7 in which the BCl₃ gas is introduced into the chamber with a BCl₃ flow rate in the range 50 to 100 sccm, optionally in the range 75 to 95 sccm, during the step of performing a second plasma etching step.

9. A method according to claim 7 or claim 8 in which the inert diluent gas is introduced into the chamber with an inert diluent gas flow rate in the range 10 to 20 sccm during the second plasma etching step.

10. A method according to any one of claims 7 to 9 in which an RF bias signal having a power in the range 500 to 700 W is applied to the substrate support during the second plasma etching step.

11. A method according to any one of claims 7 to 10 in which the metal film is a molybdenum film.

12. A method according to any previous claim in which the inert diluent gas is Argon.

13. A method according to any previous claim in which i) the mask is a photoresist mask and/or ii) the plasma is an inductively coupled plasma (ICP) and/or iii) the substrate is a semiconductor substrate, optionally a silicon substrate and/or iv) the additive-containing aluminium nitride film is an aluminium scandium nitride film defined by the formula AlₓSc_{y}N, where x + y = 1; and wherein the scandium content y is 0.35 or more, optionally about 0.4.

14. An apparatus for plasma etching an additive-containing aluminium nitride film containing an additive element selected from scandium (Sc), yttrium (Y) or erbium (Er) through a mask, the apparatus comprising:
a chamber;
a substrate support disposed within the chamber;
a gas delivery system for introducing into the chamber BCl₃ gas with a BCl₃ flow rate in sccm, Cl₂ gas with a Cl₂ flow rate in sccm and an inert diluent gas with an inert diluent flow rate in sccm;
a plasma generation device for sustaining a plasma within the chamber for etching a workpiece comprising a substrate having an additive-containing aluminium nitride film deposited thereon and a mask disposed upon the additive-containing aluminium nitride film which defines at least one trench; and
a controller configured to control the apparatus to perform plasma etching to etch the additive-containing aluminium nitride film exposed within the trench, wherein the controller controls the gas delivery system to maintain a ratio of the inert diluent gas flow rate to the sum of the BCl₃ and Cl₂ flow rates in the range 0.45:1 to 0.75:1 and a ratio of the BCl₃ flow rate to the Cl₂ flow rate in the range 0.75:1 to 1.25:1.

15. An apparatus for plasma etching an additive-containing aluminium nitride film containing an additive element selected from scandium (Sc), yttrium (Y) or erbium (Er) through a mask, the apparatus comprising:
a chamber;
a substrate support disposed within the chamber;
a gas delivery system for introducing into the chamber BCl₃ gas, Clz gas and an inert diluent gas;
a plasma generation device for sustaining a plasma within the chamber for etching a workpiece comprising a substrate having a metal film disposed thereon, an additive-containing aluminium nitride film deposited on the metal film and a mask disposed upon the additive-containing aluminium nitride film which defines at least one trench; and
a controller configured to control the apparatus to perform a first, main, plasma etching step in which BCl₃ gas, Cl₂ gas and an inert diluent gas are introduced into the chamber and a plasma is established within the chamber to etch a majority of the additive-containing aluminium nitride film exposed within the trench, and a second plasma etching step in which BCl₃ gas and an inert diluent gas are introduced into the chamber but Cl₂ gas is not introduced into the chamber and a plasma is established within the chamber to etch the remaining additive-containing aluminium nitride film exposed within the trench thereby revealing the metal film.
